# EUROPEAN PATENT SPECIFICATION

(11) **EP 4 575 033 B1**
(45) Date of publication and mention of the grant of the patent: **13.05.2026**
(21) Application number: 24219155.9
(22) Date of filing: 11.12.2024
(51) Int. Cl.: C23C 16/44, B05B 1/00, G02F 1/13, G03F 1/82, H01J 9/38, H10K 71/16, H10P 72/00

(54) **DISPLAY APPARATUS MANUFACTURING APPARATUS AND DISPLAY APPARATUS MANUFACTURING METHOD**
VORRICHTUNG ZUR HERSTELLUNG EINER ANZEIGEVORRICHTUNG UND VERFAHREN ZUR HERSTELLUNG EINER ANZEIGEVORRICHTUNG
APPAREIL DE FABRICATION D'APPAREIL D'AFFICHAGE ET PROCÉDÉ DE FABRICATION D'APPAREIL D'AFFICHAGE

(30) Priority: 14.12.2023 KR 20230182085
(43) Date of publication of application: 25.06.2025
(73) Proprietor: Samsung Display Co., Ltd., Yongin-si, Gyeonggi-do 17113 (KR)
(72) Inventor: HUCH, Sungmin, 17113 Yongin-si (KR)
(74) Representative: Marks & Clerk LLP

(56) References cited:
- CN-B- 103 811 300
- US-A1- 2019 211 445
- US-A1- 2021 032 746

## Description

### BACKGROUND

### 1. Field

The invention relates to an apparatus and a method, and more particularly, to a display apparatus manufacturing apparatus and a display apparatus manufacturing method.

### 2. Description of the Related Art

Mobility-based electronic apparatuses have been widely used. In addition to small electronic apparatuses such as mobile phones, tablet personal computers (PC) have recently been widely used as mobile electronic apparatuses.

Such mobile electronic apparatuses include a display apparatus to provide visual information such as images or videos to a user in order to support various functions. Recently, as other parts for driving a display apparatus have been miniaturized, the proportion of a display apparatus in an electronic apparatus has increased gradually and a structure capable of being bent from a flat state by a certain angle has also been developed.
US 2021/032746 A1 discloses a system for determining when a cleaning process has completed. The system relies on an increase in the amount of gas in the processing chamber that occurs when the cleaning is complete.

### SUMMARY

One or more embodiments include an apparatus and a method for improving the accuracy of determining the end point of cleaning in a chamber. The invention is set out in the appended set of claims

### BRIEF DESCRIPTION OF THE DRAWINGS

The above and other aspects, features, and advantages of the invention will be more apparent from the following description taken in conjunction with the accompanying drawings, in which:
FIG. 1 is a schematic cross-sectional view of a display apparatus manufacturing apparatus, according to an embodiment;
FIG. 2 is a schematic cross-sectional view of a display apparatus manufacturing apparatus, according to an embodiment;
FIG. 3 is a schematic cross-sectional view of a display apparatus manufacturing apparatus, according to an embodiment;
FIG. 4 is a cross-sectional view of a portion of a pressure adjusting unit, according to an embodiment;
FIG. 5 is a diagram illustrating a graph representing an opening ratio over time, according to an embodiment;
FIG. 6 is a flowchart illustrating a display apparatus manufacturing method, according to an embodiment;
FIG. 7 is a plan view schematically illustrating a display apparatus, according to an embodiment;
FIG. 8 is a cross-sectional view schematically illustrating a display apparatus, according to an embodiment; and
FIG. 9 is an equivalent circuit diagram of a pixel of a display apparatus, according to an embodiment.

### DETAILED DESCRIPTION

Reference will now be made in detail to embodiments of the invention, examples of which are illustrated in the accompanying drawings, wherein like reference numerals refer to like elements throughout. In this regard, the invention may have different forms and should not be construed as being limited to the descriptions set forth herein. Accordingly, the embodiments are merely described below, by referring to the figures, to explain aspects of the invention. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

The disclosure may include various embodiments and modifications, and particular embodiments thereof are illustrated in the drawings and will be described herein in detail. The effects and features of the invention and methods of achieving them will become apparent with reference to the invention described below in detail together with the drawings. However, the invention is not limited to the embodiments described below and may be implemented in various forms.

Hereinafter, embodiments will be described in detail with reference to the accompanying drawings, and in the following description, like reference numerals will denote like elements and redundant descriptions thereof will be omitted for conciseness.

It will be understood that although terms such as "first" and "second" may be used herein to describe various elements, these elements should not be limited by these terms and these terms are only used to distinguish one element from another element.

As used herein, the singular forms "a," "an," and "the" are intended to include the plural forms as well, unless the context clearly indicates otherwise.

It will be understood that terms such as "comprise," "include," and "have" used herein specify the presence of stated features or elements, but do not preclude the presence or addition of one or more other features or elements.

It will be understood that when a layer, region, or component is referred to as being "on" another layer, region, or component, it may be "directly on" the other layer, region, or component or may be "indirectly on" the other layer, region, or component with one or more intervening layers, regions, or components therebetween.

Sizes of components in the drawings may be exaggerated or reduced for convenience of description. In other words, because the sizes and shapes of components in the drawings are arbitrarily illustrated for convenience of description, the invention is not limited thereto.

Also, herein, the X axis, the Y axis, and the Z axis are not limited to three axes of the rectangular coordinate system and may be interpreted in a broader sense. For example, the X axis, the Y axis, and the X axis may be directed perpendicular to one another or may represent different directions that are not directed perpendicular to one another.

When a certain embodiment may be implemented differently, a particular process order may be performed differently from the described order. For example, two consecutively described processes may be performed substantially at the same time or performed in an order opposite to the described order.

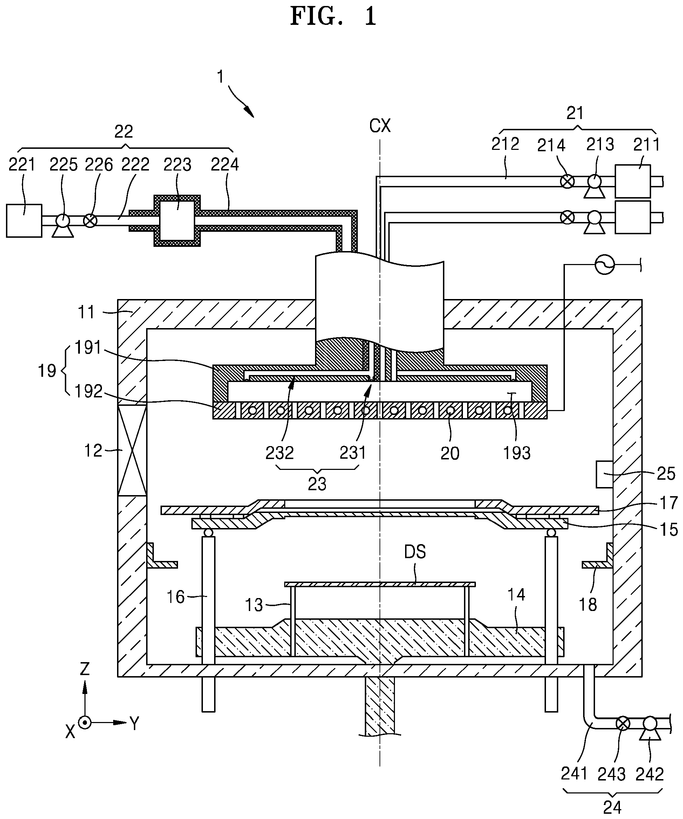

FIGS. 1 to 3 are schematic cross-sectional views of a display apparatus manufacturing apparatus 1, according to an embodiment.

In an embodiment and referring to FIGS. 1 to 3, the display apparatus manufacturing apparatus 1 may manufacture a display apparatus and may include a chamber 11, an opening/closing unit 12, a first support unit 13, a susceptor 14, a mask 15, a second support unit 16, a shadow frame 17, a third support unit 18, a head unit 19, an electrode unit 20, a process gas supply unit 21, a cleaning gas supply unit 22, a cleaning gas spray unit 23, a pressure adjusting unit 24, a sensing unit 25, and a control unit (not illustrated).

In an embodiment, the chamber 11 may provide an internal space, where the internal space provided by the chamber 11 may be sealed. In FIGS. 1 to 3, the cross-sectional shape of the chamber 11 is illustrated as a square shape. However, this is only an example and the shape of the chamber 11 is not limited thereto.

In an embodiment, the chamber 11 may be a chamber for chemical vapor deposition or plasma chemical vapor deposition. In another embodiment, the chamber 11 may be a chamber for atomic layer deposition or plasma chemical vapor deposition. In yet another embodiment, the chamber 11 may be a chamber for selectively performing chemical vapor deposition (or plasma chemical vapor deposition) and atomic layer deposition (or plasma atomic layer deposition). Hereinafter, a detailed description will be given focusing on the embodiment where the chamber 11 is a chamber for plasma chemical vapor deposition.

In an embodiment, the opening/closing unit 12 may be arranged on one side of the chamber 11 and may selectively open/close the chamber 11. For example, the opening/closing unit 12 may include a gate valve. With the chamber 11 opened by the opening/closing unit 12, a robot arm may carry in a display substrate DS to the inside of the chamber 11 or carry out the display substrate DS from the inside of the chamber 11.

In an embodiment, the susceptor 14 may be arranged in the chamber 11 and may support one surface of the display substrate DS. The susceptor 14 and the display substrate DS may surface-contact each other. The susceptor 14 may move linearly in a first direction (e.g., +Z-axis direction) and a second direction (e.g., -Z-axis direction) which is opposite to the first direction (e.g., +Z-axis direction). As the susceptor 14 moves in the first direction (e.g., +Z-axis direction), the display substrate DS may be seated on the susceptor 14, and as the susceptor 14 moves in the second direction (e.g., -Z-axis direction), the display substrate DS may be separated from the susceptor 14.

In an embodiment, the first support unit 13 may be arranged in the chamber 11 and may support one surface of the display substrate DS. The first support unit 13 may move linearly in the first direction (e.g., +Z-axis direction) and the second direction (e.g., -Z-axis direction). The first support unit 13 may be provided as a plurality of first support units 13, and each of the plurality of first support units 13 may contact the display substrate DS at a position adjacent to the edge of the display substrate DS. A plurality of holes may be arranged in the susceptor 14, and the plurality of first support units 13 may respectively pass through the plurality of holes arranged in the susceptor 14. For example, the first support unit 13 may be provided in a shape extending in the first direction (e.g., +Z-axis direction). However, this is only an example, and the shape of the first support unit 13 is not limited thereto and the first support unit 13 may be provided in a 'T' shape.

In an embodiment, the mask 15 may be arranged in the chamber 11 and may include a deposition area arranged over the display substrate DS. A plurality of holes may be arranged in the deposition area of the mask 15. Thus, a deposition material may be deposited on the display substrate DS by passing through the plurality of holes arranged in the deposition area of the mask 15.

In an embodiment, the second support unit 16 may be arranged in the chamber 11 and may support the surface side of the mask 15. The second support unit 16 may move linearly in the first direction (e.g., +Z-axis direction) and the second direction (e.g., -Z-axis direction). As the second support unit 16 moves, the mask 15 supported by the second support unit 16 may also move together with the second support unit 16. That is, the mask 15 may move linearly in the first direction (e.g., +Z-axis direction) and the second direction (e.g., -Z-axis direction).

In an embodiment, the second support unit 16 may be provided as a plurality of second support units 16, and each of the plurality of second support units 16 may contact the mask 15 at a position adjacent to the edge of the mask 15. A plurality of holes may be arranged in the susceptor 14, and the plurality of second support units 16 may respectively pass through the plurality of holes arranged in the susceptor 14. For example, the second support unit 16 may be provided in a shape extending in the first direction (e.g., +Z-axis direction). One end of the second support unit 16 that contacts the mask 15 may include a curved surface. Thus, the second support unit 16 and the mask 15 may point-contact each other. However, this is only an example, and the shape of the second support unit 16 is not limited thereto. The second support unit 16 may include a separate driving unit or an alignment unit in order to adjust the fine position of the mask 15.

In an embodiment, the shadow frame 17 may be arranged in the chamber 11 and may be arranged over the mask 15 so as to overlap the mask 15. One surface of the shadow frame 17 may be supported by the mask 15. As the mask 15 moves, the shadow frame 17 supported by the mask 15 may also move together with the mask 15. That is, the shadow frame 17 may move linearly in the first direction (e.g., +Z-axis direction) and the second direction (e.g., -Z-axis direction).

In an embodiment, the third support unit 18 may be arranged in the chamber 11 and may support the lower surface (e.g., the surface facing the -Z axis) of the shadow frame 17. The third support unit 18 may be fixed to the chamber 11 and may contact the shadow frame 17 at a position that is adjacent to the edge of the mask 15.

In an embodiment, the head unit 19 may be arranged in the chamber 11 to supply a process gas and a cleaning gas into the chamber 11. In this case, the head unit 19 may include a storage space 193 in which a process gas or a cleaning gas is stored. The head unit 19 may include a head body unit 191 connected to the process gas supply unit 21 and the cleaning gas supply unit 22. Also, the head unit 19 may include a nozzle unit 192 which is coupled to the cleaning gas supply unit 22 and connects the storage space 193 with the inside of the chamber 11 and through which a process gas or a cleaning gas is sprayed.

In an embodiment, the electrode unit 20 may be arranged at the head unit 19. For example, the electrode unit 20 may be provided as a plurality of electrode units 20 at the nozzle unit 192. In another embodiment, the electrode unit 20 may be inserted into at least one of the nozzle unit 192 and the head body unit 191. Hereinafter, for convenience of description, the electrode unit 20 will be described in detail focusing on the embodiment where a plurality of electrode units 20 are inserted into the nozzle unit 192.

In an embodiment, the process gas supply unit 21 may be arranged outside the chamber 11 and connected to the head unit 19. In this case, the process gas supply unit 21 may supply a process gas to the storage space of the head unit 19. In this case, the process gas may be supplied to the head unit 19 so as to form one of an amorphous silicon (a-Si) layer, a silicon nitride (SiNₓ) layer, and a silicon oxide (SiOₓ) layer. For example, the process gas may include a silane (SiH₄) gas, a hydrogen (H₂) gas, an ammonia (NH₃) gas, a gas including a dopant element, and/or the like. Also, the process gas may include a carrier gas such as an argon (Ar) gas, a helium (He) gas, or a nitrogen (N₂) gas. In this case, the type of a layer that may be formed with the process gas may vary depending on which gas is selected as the process gas. Hereinafter, for convenience of description, a detailed description will be given focusing on the embodiment where the process gas includes silane and nitrogen gas.

In an embodiment, the process gas supply unit 21 described above may be provided as a plurality of process gas supply units 21. In this case, the plurality of process gas supply units 21 may independently supply respective process gases to the head unit 19 by being connected to the head unit 19 while separately storing the respective process gases.

In an embodiment, the process gas supply unit 21 described above may include a process gas storage unit 211 that stores a process gas, and a process gas guide pipe 212 that connects the process gas storage unit 211 with the head unit 19 and guides the process gas from the process gas storage unit 211 to the storage space 193 of the head unit 19. Also, the process gas supply unit 21 may include a process gas pump 213 that is arranged at the process gas guide pipe 212 to flow a process gas, and a process gas blocking valve 214 that blocks or passes the process gas moving through the process gas guide pipe 212.

In an embodiment, the cleaning gas supply unit 22 may be connected to the head unit 19 separately from the process gas supply unit 21. In this case, the cleaning gas supply unit 22 may supply a cleaning gas to the head unit 19. Particularly, the cleaning gas supply unit 22 may convert the cleaning gas into plasma and supply the plasma cleaning gas to the head unit 19. In this case, the cleaning gas may include nitrogen trifluoride (NF₃).

In an embodiment, the cleaning gas supply unit 22 may include a cleaning gas storage unit 221 that stores a cleaning gas. The cleaning gas supply unit 22 may include a cleaning gas supply pipe 222 that connects the cleaning gas storage unit 221 with the head unit 19 and guides the cleaning gas from the cleaning gas storage unit 221 to the head unit 19. Also, the cleaning gas supply unit 22 may include a plasma generating unit 223 that is arranged at the cleaning gas supply pipe 222 to convert the cleaning gas into plasma. The cleaning gas supply unit 22 may include an insulating unit 224 arranged in at least a portion of the cleaning gas supply pipe 222. The cleaning gas supply unit 22 may include a cleaning gas pump 225 that is arranged in the cleaning gas supply pipe 222 to flow the cleaning gas, and a cleaning gas blocking valve 226 that selectively blocks the cleaning gas flowing through the cleaning gas supply pipe 222.

In an embodiment, the plasma generating unit 223 may have a space formed inside, and an electrode may be arranged in the space. In this case, the plasma generating unit 223 may be arranged outside the chamber 11. When the cleaning gas passes through the plasma generating unit 223, a high voltage may be applied to the electrode to convert the cleaning gas into plasma. The cleaning gas supply pipe 222 may guide the plasma cleaning gas from the plasma generating unit 223 to the head unit 19. Also, the insulating unit 224 may insulate the plasma generating unit 223 and may insulate the cleaning gas supply pipe 222 and the head unit 19.

In an embodiment, the cleaning gas spray unit 23 may be arranged at the head unit 19. Particularly, the cleaning gas spray unit 23 may be inserted into the head body unit 191. In this case, the cleaning gas spray unit 23 may supply the cleaning gas supplied from the cleaning gas supply unit 22, to at least two different portions of the head body unit 191. For example, the cleaning gas spray unit 23 may supply the cleaning gas to a central portion of the head body unit 191 and another portion of the head body unit 191 that is not the central portion of the head body unit 191.

In an embodiment, the cleaning gas spray unit 23 described above may include a first cleaning gas spray unit 231 that is connected to the cleaning gas supply unit 22 to supply the cleaning gas to the central portion of the head body unit 191. Also, the cleaning gas spray unit 23 may include a second cleaning gas spray unit 232 that is connected to the cleaning gas supply unit 22 to supply the cleaning gas to a portion of the head body unit 191 that is not the central portion of the head body unit 191. In this case, the cleaning gas spray unit 23 may be provided with a plurality of second cleaning gas spray units 232. At least two of the plurality of second cleaning gas spray units 232 may be arranged symmetrically to each other with respect to the first cleaning gas spray unit 231. Also, the plurality of second cleaning gas spray units 232 may be arranged to form a certain angle with respect to the first cleaning gas spray unit 231. In this case, each of the second cleaning gas spray units 232 may be arranged at the same distance from the first cleaning gas spray unit 231. In this case, the second cleaning gas spray unit 232 may be arranged apart from the first cleaning gas spray unit 231 in one of the X-axis direction and the Y-axis direction of FIG. 1.

In an embodiment, the pressure adjusting unit 24 may be connected to the chamber 11 to discharge the gas in the chamber 11 to the outside to adjust the pressure in the chamber 11. The pressure adjusting unit 24 may include a guide pipe 241, a pressure adjusting pump 242, and a pressure adjusting valve 243.

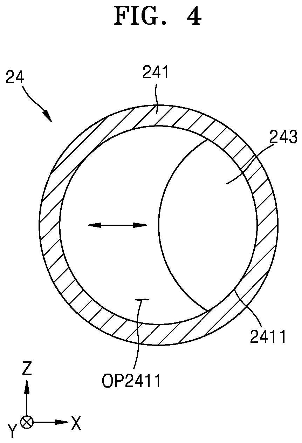

In an embodiment, the guide pipe 241 may be connected to the chamber 11. The guide pipe 241 may include a pipe flow path 2411 (see Fig. 4) communicating with the inside of the chamber 11. The gas in the chamber 11 may flow through the pipe flow path 2411.

In an embodiment, the pressure adjusting pump 242 may be connected to the guide pipe 241 and may apply a designated pressure to the pipe flow path 2411 such that the gas in the chamber 11 flows to the outside.

In an embodiment, the pressure adjusting valve 243 may be connected to the guide pipe 241 and may open or close the pipe flow path 2411 such that the pressure in the chamber 11 is within a designated range. The gas in the chamber 11 may sequentially pass through the pressure adjusting valve 243 and the pressure adjusting pump 242.

In an embodiment, the sensing unit 25 may include a pressure sensor and may sense the pressure in the chamber 11. The sensing unit 25 may be arranged in the chamber 11. The pressure adjusting valve 243 may open or close the pipe flow path 2411 based on information sensed by the sensing unit 25.

In an embodiment, the control unit (not illustrated) may control at least one of the opening/closing unit 12, the first support unit 13, the susceptor 14, the mask 15, the second support unit 16, the shadow frame 17, the third support unit 18, the head unit 19, the electrode unit 20, the process gas supply unit 21, the cleaning gas supply unit 22, the cleaning gas spray unit 23, the pressure adjusting unit 24, and the sensing unit 25. A detailed description of the control unit (not illustrated) will be given below.

In an embodiment and referring to FIG. 1, the display substrate DS may be arranged in the chamber 11. The second support unit 16 may move in the first direction (e.g., +Z-axis direction), and the susceptor 14 may move in the second direction (e.g., -Z-axis direction). As the second support unit 16 moves in the first direction (e.g., +Z-axis direction), the mask 15 supported by the second support unit 16 and the shadow frame 17 supported by the mask 15 may also move in the first direction (e.g., +Z-axis direction). Also, as the susceptor 14 moves in the second direction (e.g., -Z-axis direction), the first support unit 13 may also move in the second direction (e.g., -Z-axis direction). An end portion of the first support unit 13 may be located over the upper surface of the susceptor 14. The opening/closing unit 12 may open the chamber 11, and the display substrate DS may be seated on the first support unit 13 through the opening/closing unit 12. That is, the display substrate DS and the end portion of the first support unit 13 may contact each other.

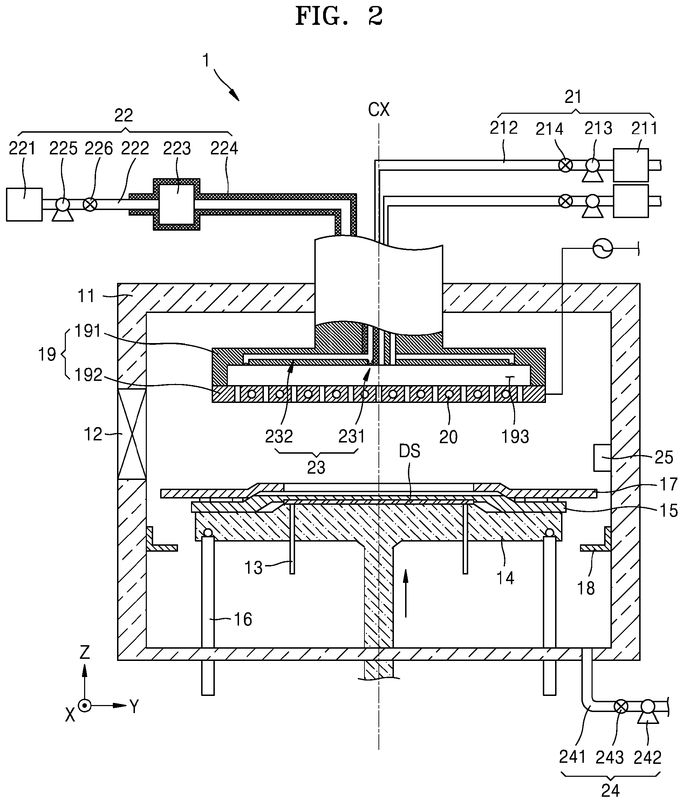

In an embodiment and referring to FIG. 2, a deposition material may be deposited on the display substrate DS. When the display substrate DS is seated on the first support unit 13, the susceptor 14 may move in the first direction (e.g., +Z-axis direction). As the susceptor 14 moves in the first direction (e.g., +Z-axis direction), the display substrate DS may also move in the first direction (e.g., +Z-axis direction) while being supported by the susceptor 14 and the first support unit 13 may also move in the first direction (e.g., +Z-axis direction) together with the susceptor 14. Also, the susceptor 14 and the mask 15 may contact each other, the mask 15 may move in the first direction (e.g., +Z-axis direction) while being supported by the susceptor 14, and the shadow frame 17 may also move in the first direction (e.g., +Z-axis direction) while being supported by the mask 15. In this embodiment, the second support unit 16 need not move, and thus, the second support unit 16 and the mask 15 may be separated from each other.

In an embodiment, the process gas supply unit 21 may supply the process gas to the head unit 19. In this embodiment, a voltage may be applied to the electrode unit 20 to convert the process gas into plasma and deposit some of the plasma process gas onto the display substrate DS. In this embodiment, the display apparatus manufacturing apparatus 1 may form one layer among various layers (or films) of the display substrate DS. For example, the display apparatus manufacturing apparatus 1 may form an amorphous silicon layer on the display substrate DS. In another embodiment, the display apparatus manufacturing apparatus 1 may also form an inorganic layer among the thin film encapsulation layers on the display substrate DS. Hereinafter, for convenience of description, the display apparatus manufacturing apparatus 1 will be described in detail focusing on the case of forming an inorganic layer among the thin film encapsulation layers on the display substrate DS.

In an embodiment and as described above, while performing a process of depositing a portion of the deposition gas onto the display substrate DS, the pressure adjusting unit 24 may discharge the gas in the chamber 11 to the outside. The pressure adjusting valve 243 may open or close the pipe flow path 2411 such that the pressure in the chamber 11 is within a designated range.

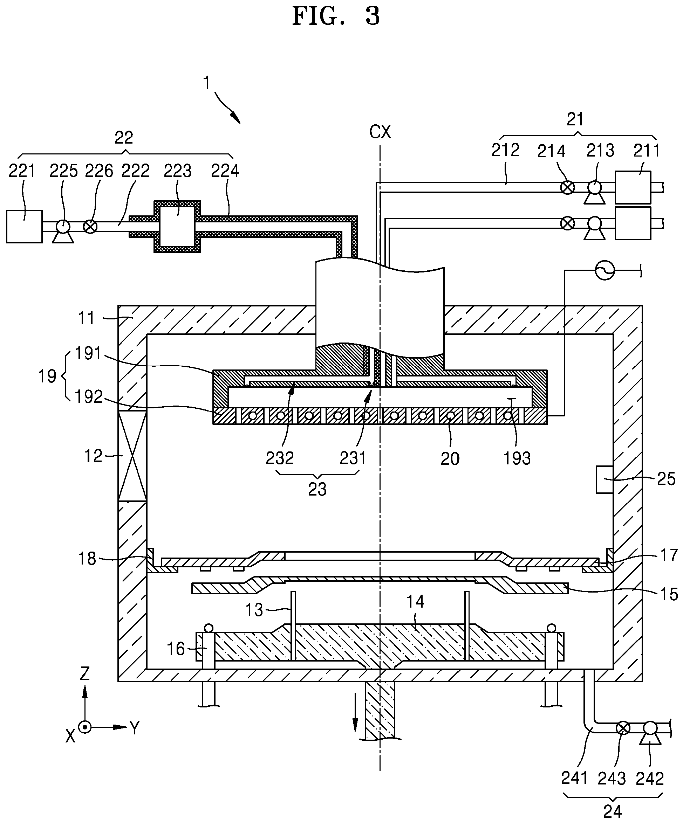

In an embodiment and referring to FIG. 3, the second support unit 16 and the susceptor 14 may move in the second direction (e.g., -Z-axis direction). As the second support unit 16 moves in the second direction (e.g., -Z-axis direction), the mask 15 supported by the second support unit 16 and the shadow frame 17 supported by the mask 15 may also move in the second direction (e.g., -Z-axis direction). As the shadow frame 17 moves in the second direction (e.g., -Z-axis direction), the shadow frame 17 may contact the third support unit 18. That is, as the shadow frame 17 is supported by the third support unit 18, the shadow frame 17 may move in the second direction (e.g., -Z-axis direction) only to a position where it contacts the third support unit 18. The display substrate DS with the deposition material deposited thereon through the opening/closing unit may be carried out to the outside, and a new display substrate DS may be carried into the inside of the chamber 11. The process described with reference to FIG. 1 may be repeated again.

In an embodiment, the above process may be repeated multiple times. The display apparatus manufacturing apparatus 1 may perform a cleaning process when the preset number of times is reached while performing the above operation multiple times.

Particularly, in an embodiment, in the case of supplying the process gas to deposit a portion of the process gas onto the display substrate DS, a portion of the process gas may be adsorbed onto the chamber 11, the susceptor 14, the head unit 19, and/or the like in addition to the display substrate DS. In this case, when a new display substrate DS is deposited afterwards, the concentration of the deposition gas need not be uniform and the deposition quality and the deposition efficiency may be degraded due to dropping of foreign substances, mixing of foreign substances, or the like. In order to prevent this, the inside of the chamber 11 may be cleaned with the cleaning gas after performing a deposition process a certain number of times as described above.

In an embodiment, the cleaning gas supply unit 22 may convert the cleaning gas into plasma and supply the plasma cleaning gas to the cleaning gas spray unit 23. When the cleaning gas is continuously supplied to the storage space 193 as described above, the cleaning gas may be sprayed through the nozzle unit 192. In this embodiment, the fluorine radical (F radical) of the cleaning gas may react with a portion of the deposition gas adsorbed onto the inner wall of the chamber 11, the susceptor 14, the head unit 19, and/or the like to remove a portion of the deposition gas.

In an embodiment and as described above, while cleaning the chamber 11, the susceptor 14, the head unit 19, and the like through the cleaning gas, a voltage may be applied to the electrode unit 20. In this embodiment, the reaction between the cleaning gas and a portion of the process gas deposited onto the chamber 11, the susceptor 14, the head unit 19, and the like may be promoted by the electrode unit 20 and thus the gas may be rapidly removed.

In an embodiment, during the cleaning process described above, the pressure adjusting unit 24 may discharge the gas in the chamber 11 to the outside. The pressure adjusting valve 243 may open or close the pipe flow path 2411 such that the pressure in the chamber 11 is within a designated range.

FIG. 4 is a cross-sectional view of a portion of the pressure adjusting unit 24, according to an embodiment.

In an embodiment and referring to FIGS. 1 to 4, a portion of the pipe flow path 2411 of the guide pipe 241 may be closed by the pressure adjusting valve 243 and the other portion thereof may be opened.

Hereinafter, an opening opened by the pressure adjusting valve 243 in the pipe flow path 2411 will be referred to as a passage opening OP2411. Also, the ratio of the cross-sectional area of the passage opening OP2411 to the cross-sectional area of the pipe flow path 2411 will be referred to as an opening ratio. That is, when the opening ratio is about 100%, the pipe flow path 2411 may be completely opened, when the opening ratio is about 0%, the pipe flow path 2411 may be completely closed, and when the opening ratio is about 50%, half of the pipe flow path 2411 may be opened. The pressure adjusting valve 243 may flexibly adjust the opening ratio. Thus, the pressure adjusting unit 24 may adjust the opening ratio such that the pressure in the chamber 11 is uniform.

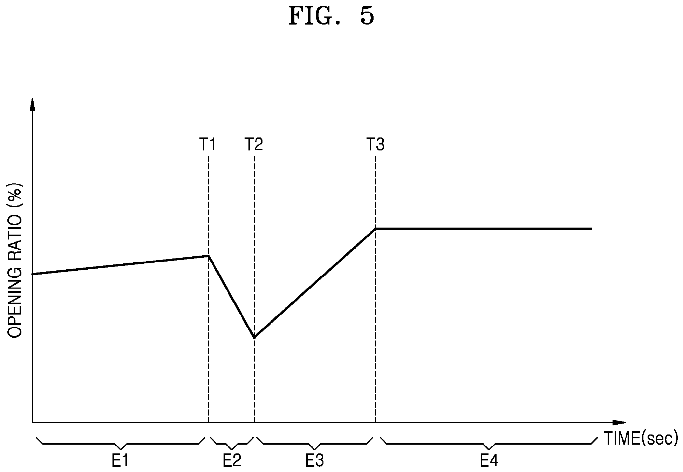

FIG. 5 is a diagram illustrating a graph representing an opening ratio over time, according to an embodiment.

Particularly, in the graph illustrated in FIG. 5, the horizontal axis represents time in units of seconds (sec), and the vertical axis represents the opening ratio in units of %.

In an embodiment and referring to FIGS. 3 to 5, the control unit (not illustrated) may determine the end point of the cleaning. That is, the control unit (not illustrated) may determine the end point of the cleaning process in the chamber 11.

In an embodiment, the opening ratio may be adjusted by the pressure adjusting unit 24 so that the pressure in the chamber 11 is within a designated range.

In an embodiment, when the cleaning starts, the opening ratio may increase until a first time T1. The period from the start of the cleaning to the first time T1 will be referred to as a first period E1. That is, the hourly variation of the opening ratio may be positive in the first period E1.

In an embodiment, when the cleaning starts, as the cleaning gas is supplied from the cleaning gas supply unit 22 to the head unit 19, a portion of the head unit 19 close to a central axis CX thereof may be first cleaned. For example, the flow rate of the cleaning gas sprayed by the first cleaning gas spray unit 231 may be greater than the flow rate of the cleaning gas sprayed by the second cleaning gas spray unit 232. Thus, a portion of the head unit 19 close to the central axis CX may be first cleaned.

In an embodiment, as a portion of the head unit 19 close to the central axis CX is first cleaned, the temperature in the chamber 11 may increase and accordingly the pressure in the chamber 11 may increase. Thus, the pressure adjusting unit 24 may increase the opening ratio such that the pressure in the chamber 11 is within a designated range.

In an embodiment, the opening ratio may decrease from the first time T1 to a second time T2. The period from the first time T1 to the second time T2 will be referred to as a second period E2. That is, the hourly variation of the opening ratio may be negative in the second period E2.

According to switching from the first period E1 to the second period E2, and in an embodiment, a portion of the head 19 being cleaned may move away from the central axis CX. Thus, the amount of heat generated by the cleaning in the second period E2 may be less than that in the first period E1. Thus, the temperature in the chamber 11 may decrease and accordingly the pressure in the chamber 11 may decrease. Thus, the pressure adjusting unit 24 may reduce the opening ratio such that the pressure in the chamber 11 is within a designated range.

In an embodiment, the opening ratio may increase from the second time T2 to a third time T3. The period from the second time T2 to the third time T3 will be referred to as a third period E3. That is, the hourly variation of the opening ratio may be positive in the third period E3.

In an embodiment, according to switching from the second period E2 to the third period E3, the cleaning of the head unit 19 may be completed and the cleaning of other components including the inner wall of the chamber 11 may be performed. For example, the cleaning of the inner wall of the chamber 11, the susceptor 14, the mask 15, the shadow frame 17, and the like may be performed.

Thus, in an embodiment, the amount of heat generated by the cleaning in the third period E3 may be greater than that in the second period E2. The temperature in the chamber 11 may increase and accordingly the pressure in the chamber 11 may increase. The pressure adjusting unit 24 may increase the opening ratio such that the pressure in the chamber 11 is within a designated range.

In an embodiment, after the third time T3, the hourly variation of the opening ratio may be small or about 0. The period after the third time T3 will be referred to as a fourth period E4. That is, in the fourth period E4, the hourly variation of the opening ratio may be within a designated range.

In an embodiment, in the fourth period E4, the cleaning in the chamber 11 may be completed. Thus, the amount of heat generated by the cleaning in the fourth period E4 may be about 0 or small. Thus, the variation of the temperature in the chamber 11 may be about 0 or small and accordingly the pressure in the chamber 11 may be uniform. Thus, the pressure adjusting unit 24 may adjust the hourly variation of the opening ratio such that the pressure in the chamber 11 is within a designated range. For example, in the fourth period E4, the hourly variation of the opening ratio may be about 0.

In an embodiment, when the hourly variation of the opening ratio is within a designated range, the control unit (not illustrated) may determine that the cleaning has been ended. For example, the control unit (not illustrated) may determine that the cleaning has been ended, when the hourly variation of the opening ratio is about 0.

In an embodiment, when determining that the cleaning has been ended, the control unit (not illustrated) may control the cleaning gas supply unit 22 to stop supplying the cleaning gas to the head unit 19. Thereafter, a new deposition process described above with reference to FIG. 1 may be started. That is, when determining that the cleaning has been ended, the control unit (not illustrated) may control the process gas supply unit 21 to supply the process gas to the head unit 19.

In this process, because the end point of the cleaning is determined not by the naked eye but by the opening ratio, the accuracy in determination of the end point of the cleaning may be improved.

Thus, the phenomenon of an increase in the cleaning time and a waste of the cleaning gas due to continuously spraying the cleaning gas even after the cleaning has been completed may be reduced. As the cleaning time is reduced, the damage to various components due to long-time exposure of the cleaning gas may be reduced. The phenomenon in which particles having AIF components are formed by the reaction of fluorine radicals (F radicals) and aluminum (Al) of the head unit 19 may be reduced. Also, as the cleaning time is reduced, the display apparatus production of the display apparatus manufacturing apparatus may increase. Also, the phenomenon in which incomplete cleaning occurs due to stopping the spraying of the cleaning gas before the cleaning is completed may also be reduced.

In an embodiment, the control unit (not illustrated) may determine that the cleaning has been ended when the opening ratio sequentially satisfies the first period E1, the second period E2, the third period E3, and the fourth period E4. That is, the control unit (not illustrated) may determine that the cleaning has been ended only when the hourly variation of the opening ratio is sequentially positive, negative, and positive again and finally approaches about 0. Thus, as the determination of the end point of the cleaning by the control unit (not illustrated) becomes stricter, the phenomenon of mis-determination of the end point of the cleaning by the control unit (not illustrated) may be reduced.

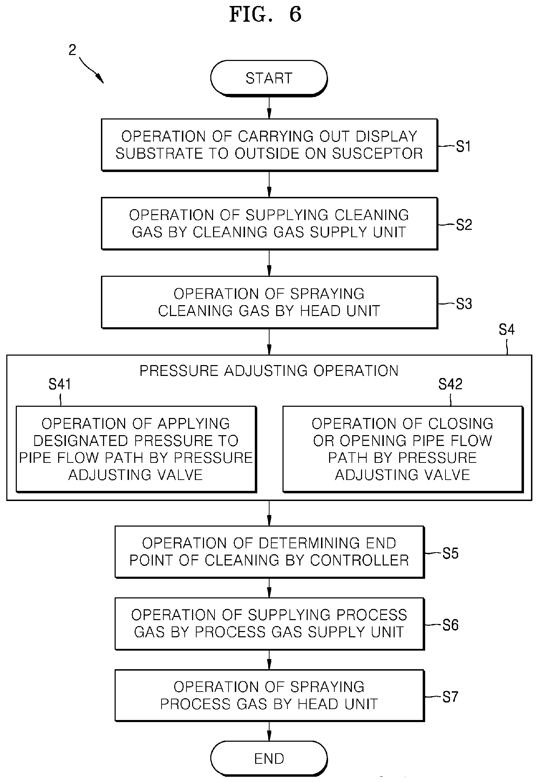

FIG. 6 is a flowchart illustrating a display apparatus manufacturing method 2, according to an embodiment.

In an embodiment and referring to FIGS. 1 to 6, the display apparatus manufacturing method 2 may include an operation S1 of carrying out (removing) the display substrate DS to the outside of the chamber 11 from the susceptor 14, an operation S2 of supplying the cleaning gas to the head unit 19 by the cleaning gas supply unit 22, an operation S3 of spraying the cleaning gas into the chamber 11 by the head unit 19, a pressure adjusting operation S4 of adjusting the pressure in the chamber 11 by the pressure adjusting unit 24, and an operation S5 of determining the end point of cleaning by the control unit (not illustrated).

In an embodiment, the pressure adjusting operation S4 may include an operation S41 in which the pressure adjusting pump 242 applies a designated pressure to the pipe flow path 2411, and an operation S42 in which the pressure adjusting valve opens or closes the pipe flow path 2411 such that the pressure in the chamber 11 is within a designated range.

In this embodiment, when the hourly variation of the opening ratio is within a designated range, the control unit (not illustrated) may calculate the opening ratio and determine that the cleaning has been ended. When determining that the cleaning has been ended, the control unit (not illustrated) may control the cleaning gas supply unit 22 to stop supplying the cleaning gas to the head unit 19.

In an embodiment, the display apparatus manufacturing method 2 may further include an operation S6 in which the process gas supply unit 21 supplies the process gas to the head unit 19, and an operation S7 in which the head unit 19 sprays the process gas into the chamber 11. In this embodiment, when determining that the cleaning has been ended, the control unit (not illustrated) may control the process gas supply unit 21 to supply the process gas to the head unit 19.

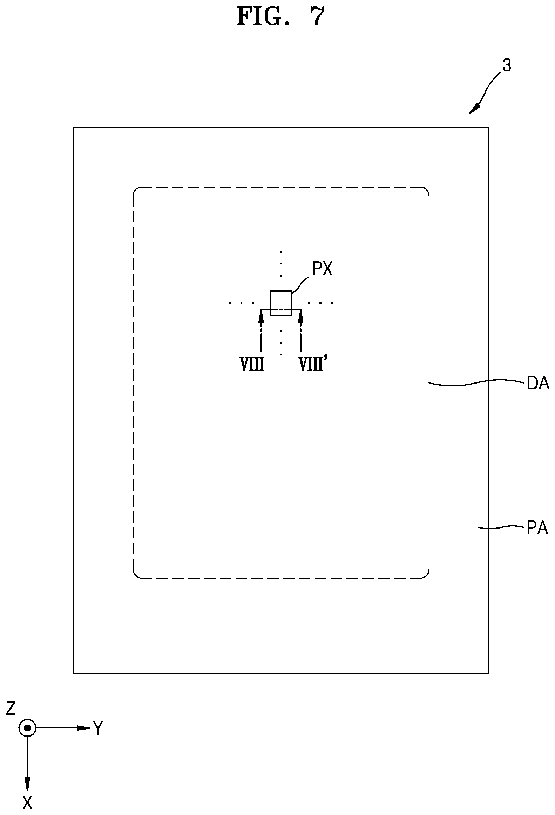

FIG. 7 is a plan view schematically illustrating a display apparatus 3, according to an embodiment.

In an embodiment and referring to FIG. 7, the display apparatus 3 manufactured may include a display area DA and a peripheral area PA located outside the display area DA. The display apparatus 3 may provide an image through an array of a plurality of pixels PX two-dimensionally arranged in the display area DA.

In an embodiment, the peripheral area PA may be an area not providing an image and may entirely or partially surround the display area DA. A driver or the like for providing an electrical signal or power to a pixel circuit corresponding to each of the pixels PX may be arranged in the peripheral area PA. A pad, which is an area to which an electronic device, a printed circuit board, or the like may be electrically connected, may be arranged in the peripheral area PA.

Hereinafter, the display apparatus 3 will be described as including an organic light emitting diode OLED as a light emitting element. However, the display apparatus 3 is not limited thereto. In another embodiment, the display apparatus 3 may include a light emitting display apparatus including an inorganic light emitting diode, that is, an inorganic light emitting display apparatus. The inorganic light emitting diode may include a PN diode including inorganic semiconductor-based materials. When a forward voltage is applied to the PN junction diode, holes and electrons may be injected thereinto and energy generated by the recombination of the holes and electrons may be converted into light energy to emit light of a certain color. The inorganic light emitting diode described above may have a width of several to several hundred micrometers, and in some embodiments, the inorganic light emitting diode may be referred to as a micro LED. In another embodiment, the display apparatus 3 may include a quantum dot light emitting display apparatus.

Moreover, in an embodiment, the display apparatus 3 may be used as a display screen of various products such as televisions, notebook computers, monitors, billboards, and Internet of Things (IoT) apparatuses as well as portable electronic apparatuses such as mobile phones, smart phones, tablet personal computers (PCs), mobile communication terminals, electronic notebooks, electronic books, portable multimedia players (PMPs), navigation, and Ultra Mobile PCs (UMPCs). Also, the display apparatus 3, according to an embodiment, may be used in wearable devices such as smart watches, watch phones, glasses-type displays, and head-mounted displays (HMDs). Also, the display apparatus 3, according to an embodiment, may be used as a center information display (CID) arranged at a vehicle's instrument panel or a vehicle's center fascia or dashboard, a room mirror display replacing a vehicle's side mirror, or a display screen arranged at a rear side of a vehicle's front seat as entertainment for a vehicle's rear seat.

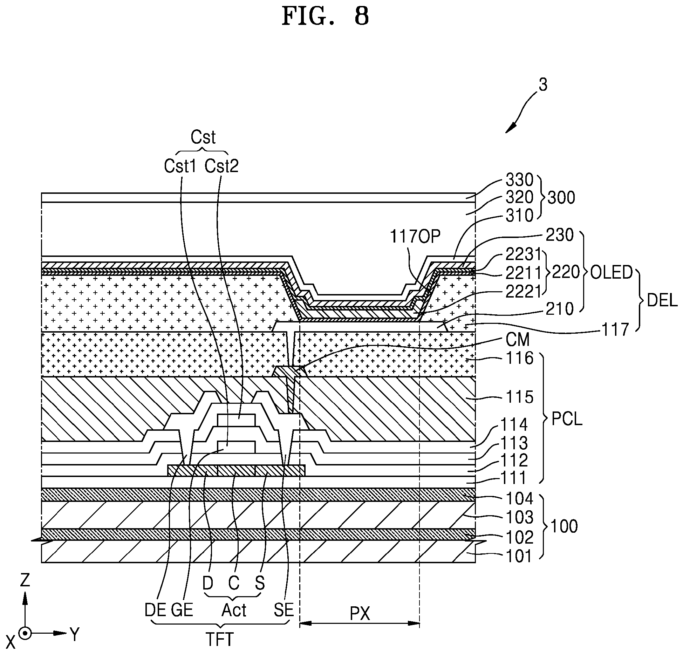

FIG. 8 is a cross-sectional view schematically illustrating a display apparatus, according to an embodiment, and may correspond to a cross-sectional view of the display apparatus taken along line VIII-VIII' of FIG. 7.

In an embodiment and referring to FIG. 8, the display apparatus 3 may include a stack structure of a substrate 100, a pixel circuit layer PCL, a display element layer DEL, and an encapsulation layer 300.

In an embodiment, the substrate 100 may have a multilayer structure including a base layer including a polymer resin and an inorganic layer. For example, the substrate 100 may include a base layer including a polymer resin and a barrier layer of an inorganic insulating layer. For example, the substrate 100 may include a first base layer 101, a first barrier layer 102, a second base layer 103, and a second barrier layer 104 that are sequentially stacked. The first base layer 101 and the second base layer 103 may include polyimide (PI), polyethersulphone (PES), polyarylate, polyetherimide (PEI), polyethylene naphthalate (PEN), polyethylene terephthalate (PET), polyphenylene sulfide (PPS), polycarbonate, cellulose triacetate (TAC), and/or cellulose acetate propionate (CAP). The first barrier layer 102 and the second barrier layer 104 may include an inorganic insulating material such as silicon oxide, silicon oxynitride, and/or silicon nitride. The substrate 100 may be flexible.

In an embodiment, the pixel circuit layer PCL may be arranged over the substrate 100. FIG. 8 illustrates that the pixel circuit layer PCL includes a thin film transistor TFT, and a buffer layer 111, a first gate insulating layer 112, a second gate insulating layer 113, an interlayer insulating layer 114, a first planarization insulating layer 115, and a second planarization insulating layer 116 that are arranged under and/or over the elements of the thin film transistor TFT.

In an embodiment, the buffer layer 111 may reduce or block the penetration of foreign materials, moisture, or external air from the bottom of the substrate 100 and may provide a flat surface on the substrate 100. The buffer layer 111 may include an inorganic insulating material such as silicon oxide, silicon oxynitride, or silicon nitride and may be formed in a single-layer or multilayer structure including the above material.

In an embodiment, the thin film transistor TFT may be disposed over the buffer layer 111 and may include a semiconductor layer Act, and the semiconductor layer Act may include polysilicon (poly-Si). In another embodiment, the semiconductor layer Act may include amorphous silicon (a-Si), may include an oxide semiconductor, or may include an organic semiconductor or the like. The semiconductor layer Act may include a channel area C, a source area S and a drain area D respectively arranged on both sides of the channel area C. A gate electrode GE may overlap the channel area C.

In an embodiment, the gate electrode GE may include a low-resistance metal material. The gate electrode GE may include a conductive material including molybdenum (Mo), aluminum (Al), copper (Cu), titanium (Ti), or the like and may include a single layer or multiple layers including the above material.

In an embodiment, the first gate insulating layer 112 may be disposed between the semiconductor layer Act and the gate electrode GE and may include an inorganic insulating material such as silicon oxide (SiO₂), silicon nitride (SiNₓ), silicon oxynitride (SiON), aluminum oxide (Al₂O₃), titanium oxide (TiO₂), tantalum oxide (Ta₂O₅), and hafnium oxide (HfO₂), or zinc oxide (ZnOₓ). The zinc oxide (ZnOₓ) may include zinc oxide (ZnO) and/or zinc peroxide (ZnO₂).

In an embodiment, the second gate insulating layer 113 may be provided to cover the gate electrode GE. Like the first gate insulating layer 112, the second gate insulating layer 113 may include an inorganic insulating material such as silicon oxide (SiO₂), silicon nitride (SiNₓ), silicon oxynitride (SiON), aluminum oxide (Al₂O₃), titanium oxide (TiO₂), tantalum oxide (Ta₂O₅)), hafnium oxide (HfO₂), or zinc oxide (ZnOₓ). The zinc oxide (ZnOₓ) may include zinc oxide (ZnO) and/or zinc peroxide (ZnO₂).

In an embodiment, an upper electrode Cst2 of a storage capacitor Cst may be arranged over the second gate insulating layer 113. The upper electrode Cst2 may overlap the gate electrode GE disposed thereunder. In this case, the gate electrode GE and the upper electrode Cst2 overlapping each other with the second gate insulating layer 113 disposed therebetween may form the storage capacitor Cst. That is, the gate electrode GE may function as a lower electrode Cst1 of the storage capacitor Cst.

In an embodiment, the storage capacitor Cst and the thin film transistor TFT may be formed to overlap each other. In some embodiments, the storage capacitor Cst may be formed not to overlap the thin film transistor TFT.

In an embodiment, the upper electrodes Cst2 may include aluminum (Al), platinum (Pt), palladium (Pd), silver (Ag), magnesium (Mg), gold (Au), nickel (Ni), neodymium (Nd), iridium (Ir), chromium (Cr), calcium (Ca), molybdenum (Mo), titanium (Ti), tungsten (W), and/or copper (Cu) and may include a single layer or multiple layers of the above material.

In an embodiment, the interlayer insulating layer 114 may cover the upper electrode Cst2 and may include silicon oxide (SiO₂), silicon nitride (SiNₓ), silicon oxynitride (SiON), aluminum oxide (Al₂O₃), titanium oxide (TiO₂), tantalum oxide (Ta₂O₅)), hafnium oxide (HfO₂), or zinc oxide (ZnOₓ). The zinc oxide (ZnOₓ) may include zinc oxide (ZnO) and/or zinc peroxide (ZnO₂). The interlayer insulating layer 114 may have a single-layer or multiple-layer structure including the above inorganic insulating material.

In an embodiment, each of the drain electrode DE and the source electrode SE may be located over the interlayer insulating layer 114. The drain electrode DE and the source electrode SE may be respectively connected to the drain area D and the source area S through contact holes formed in the insulating layers thereunder. The drain electrode DE and the source electrode SE may include a material having high conductivity. The drain electrode DE and the source electrode SE may include a conductive material including molybdenum (Mo), aluminum (Al), copper (Cu), titanium (Ti), or the like and may include a single layer or multiple layers including the above material. In an embodiment, the drain electrode DE and the source electrode SE may have a multilayer structure of Ti/Al/Ti.

In an embodiment, the first planarization insulating layer 115 may cover the drain electrode DE and the source electrode SE and may include an organic insulating material such as a general-purpose polymer such as polymethylmethacrylate (PMMA) or polystyrene (PS), a polymer derivative having a phenolic group, an acrylic polymer, an imide-based polymer, an aryl ether-based polymer, an amide-based polymer, a fluorine-based polymer, a p-xylene-based polymer, a vinyl alcohol-based polymer, or any blend thereof.

In an embodiment, the second planarization insulating layer 116 may be arranged over the first planarization insulating layer 115 and may include the same material as the first planarization insulating layer 115 and may include an organic insulating material such as a general-purpose polymer such as polymethylmethacrylate (PMMA) or polystyrene (PS), a polymer derivative having a phenolic group, an acrylic polymer, an imide-based polymer, an aryl ether-based polymer, an amide-based polymer, a fluorine-based polymer, a p-xylene-based polymer, a vinyl alcohol-based polymer, or any blend thereof.

In an embodiment, the display element layer DEL may be arranged over the pixel circuit layer PCL having the above structure and may include an organic light emitting diode OLED as a display element (i.e., a light emitting element), where the organic light emitting diode OLED may include a stack structure of a pixel electrode 210, an intermediate layer 220, and a common electrode 230. For example, the organic light emitting diode OLED may emit red, green, or blue light or may emit red, green, blue, or white light. The organic light emitting diode OLED may emit light through an emission area, and the emission area may be defined as a pixel PX.

In an embodiment, the pixel electrode 210 of the organic light emitting diode OLED may be electrically connected to the thin film transistor TFT through contact holes formed in the second planarization insulating layer 116, the first planarization insulating layer 115 and a contact metal CM arranged over the first planarization insulating layer 115.

In an embodiment, the pixel electrode 210 may include a conductive oxide such as indium tin oxide (ITO), indium zinc oxide (IZO), zinc oxide (ZnO), indium oxide (In₂O₃), indium gallium oxide (IGO), or aluminum zinc oxide (AZO). In another embodiment, the pixel electrode 210 may include a reflective layer including silver (Ag), magnesium (Mg), aluminum (Al), platinum (Pt), palladium (Pd), gold (Au), nickel (Ni), neodymium (Nd), iridium (Ir), chromium (Cr), or any compound thereof. In still another embodiment, the pixel electrode 210 may further include a layer formed of ITO, IZO, ZnO, or In₂O₃ over/under the reflective layer.

In an embodiment, a bank layer 117 including an opening 117OP exposing a center portion of the pixel electrode 210 may be arranged over the pixel electrode 210. The bank layer 117 may include an organic insulating material and/or an inorganic insulating material. The opening 117OP may define an emission area of light emitted from the organic light emitting diode OLED. For example, the size/width of the opening 117OP may correspond to the size/width of the emission area. Thus, the size and/or width of the pixel PX may depend on the size and/or width of the opening 117OP of the bank layer 117 corresponding thereto.

In an embodiment, the intermediate layer 220 may include an emission layer 2221 formed to correspond to the pixel electrode 210, where the emission layer 2221 may include a high-molecular weight or low-molecular weight organic material for emitting light of a certain color. In another embodiment, the emission layer 2221 may include an inorganic light emitting material or may include quantum dots.

In an embodiment, the intermediate layer 220 may include a first functional layer 2211 and a second functional layer 2231 respectively arranged under and over the emission layer 2221. The first functional layer 2211 may include, for example, a hole transport layer (HTL) or may include an HTL and a hole injection layer (HIL). The second functional layer 2231 may be a component arranged over the emission layer 2221 and may include an electron transport layer (ETL) and/or an electron injection layer (EIL). Like the common electrode 230 described below, the first functional layer 2211 and/or the second functional layer 2231 may be a common layer formed to entirely cover the substrate 100.

In an embodiment, the common electrode 230 may be arranged over the pixel electrode 210 and may overlap the pixel electrode 210. The common electrode 230 may include a conductive material having a low work function. For example, the common electrode 230 may include a (semi)transparent layer including silver (Ag), magnesium (Mg), aluminum (Al), platinum (Pt), palladium (Pd), gold (Au), nickel (Ni), neodymium (Nd), iridium (Ir), chromium (Cr), lithium (Li), calcium (Ca), or any alloy thereof. In another embodiment, the common electrode 230 may further include a layer such as ITO, IZO, ZnO, or In₂O₃ disposed over the (semi)transparent layer including the above material. The common electrode 230 may be integrally formed to entirely cover the substrate 100.

In an embodiment, the encapsulation layer 300 may be arranged over the display element layer DEL and may cover the display element layer DEL. The encapsulation layer 300 may include at least one inorganic encapsulation layer and at least one organic encapsulation layer, and as an embodiment, FIG. 8 illustrates that the encapsulation layer 300 includes a first inorganic encapsulation layer 310, an organic encapsulation layer 320, and a second inorganic encapsulation layer 330 that are sequentially stacked.

In an embodiment, the first inorganic encapsulation layer 310 and the second inorganic encapsulation layer 330 may include one or more inorganic materials among aluminum oxide, titanium oxide, tantalum oxide, hafnium oxide, zinc oxide, silicon oxide, silicon nitride, and silicon oxynitride. The organic encapsulation layer 320 may include a polymer-based material. The polymer-based material may include acryl-based resin, epoxy-based resin, polyimide, polyethylene, or the like. In an embodiment, the organic encapsulation layer 320 may include acrylate. The organic encapsulation layer 320 may be formed by curing a monomer or applying a polymer. The organic encapsulation layer 320 may be transparent.

Although not illustrated, in an embodiment, a touch sensor layer may be arranged over the encapsulation layer 300, and an optical functional layer may be arranged over the touch sensor layer. The touch sensor layer may be configured to obtain coordinate information according to an external input, for example, a touch event. The optical functional layer may reduce the reflectance of light (external light) incident from the outside toward the display apparatus and/or may improve the color purity of light emitted from the display apparatus. In an embodiment, the optical functional layer may include a phase retarder and/or a polarizer, where the phase retarder may be a film type or a liquid crystal coating type and may include a λ/2 phase retarder and/or a λ/4 phase retarder. The polarizer may also be a film type or a liquid crystal coating type. The film type may include a stretchable synthetic resin film, and the liquid crystal coating type may include liquid crystals arranged in a certain array. The phase retarder and the polarizer may further include a protection film.

In an embodiment, an adhesive member may be arranged between the touch electrode layer and the optical functional layer. The adhesive member may include a general adhesive member as known in the art, without limitation. In an embodiment, the adhesive member may include a pressure sensitive adhesive (PSA).

In an embodiment, the display substrate DS described with reference to FIGS. 1 to 6 may include the substrate 100 described with reference to FIG. 8. Also, the deposition material described with reference to FIGS. 1 to 6 may include the intermediate layer 220 (e.g., the emission layer 2221) described with reference to FIG. 8.

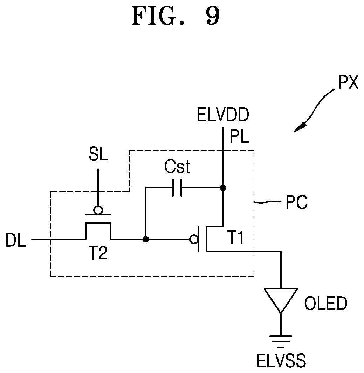

FIG. 9 is an equivalent circuit diagram of a pixel of the display apparatus 3, according to an embodiment.

In an embodiment, each pixel PX may include a pixel circuit PC and a display element, for example, an organic light emitting diode OLED, connected to the pixel circuit PC. The pixel circuit PC may include a first thin film transistor T1, a second thin film transistor T2, and a storage capacitor Cst. Each pixel PX may emit, for example, red, green, blue, or white light from the organic light emitting diode OLED.

In an embodiment, as a switching thin film transistor, the second thin film transistor T2 may be connected to a scan line SL and a data line DL and may be configured to transmit a data voltage input from the data line DL to the first thin film transistor T1, based on a switching voltage input from the scan line SL. The storage capacitor Cst may be connected to the second thin film transistor T2 and a driving voltage line PL and may be configured to store a voltage corresponding to the difference between a voltage received from the second thin film transistor T2 and a first power voltage ELVDD supplied to the driving voltage line PL.

In an embodiment, as a driving thin film transistor, the first thin film transistor T1 may be connected to the driving voltage line PL and the storage capacitor Cst and may be configured to control a driving current flowing from the driving voltage line PL through the organic light emitting diode OLED in response to a voltage value stored in the storage capacitor Cst. The organic light emitting diode OLED may emit light with a certain brightness according to the driving current. An opposite electrode (e.g., a cathode) of the organic light emitting diode OLED may be supplied with a second power voltage ELVSS.

FIG. 9 illustrates an embodiment where the pixel circuit PC includes two thin film transistors and one storage capacitor. However, the invention is not limited thereto. The number of thin film transistors and the number of storage capacitors may be variously modified according to the design of the pixel circuit PC. For example, the pixel circuit PC may further include four or more thin film transistors in addition to the two thin film transistors described above.

According to an embodiment, it may be possible to reduce phenomena such as waste of the cleaning gas, damage to various components, and degradation of productivity that may occur due to continuing to spray the cleaning gas even after the cleaning is completed.

According to an embodiment, it may be possible to reduce the phenomenon of incomplete cleaning caused by stopping spraying the cleaning gas before the cleaning is completed.

Moreover, effects of the invention are not limited to the effects described above, and other effects not described herein will be clearly understood by those of ordinary skill in the art.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope of the invention. Moreover, the embodiments or parts of the embodiments may be combined in whole or in part without departing from the scope of the invention.

## Claims

1. A display manufacturing apparatus comprising:
a chamber (11);
a susceptor (14) arranged in the chamber (11) and configured to support a display substrate;
a head unit (19) arranged in the chamber (11) and configured to spray a cleaning gas into the chamber (11);
a cleaning gas supply unit (22) configured to supply the cleaning gas to the head unit (19);
a pressure adjusting unit (24) configured to adjust a pressure in the chamber (11); and
a control unit configured to determine an end point of cleaning,
wherein the pressure adjusting unit (24) comprises:
a guide pipe (241) connected to the chamber (11) and comprising a pipe flow path (2411) communicating with an inside of the chamber (11);
a pressure adjusting pump (242) connected to the guide pipe (241) and configured to apply a designated pressure to the pipe flow path (2411) such that a gas in the chamber (11) flows to an outside thereof; and
a pressure adjusting valve (243) connected to the guide pipe (241) and configured to open or close the pipe flow path (2411) such that the pressure in the chamber (11) is within a designated range,
wherein the control unit is configured to calculate an opening ratio that is a ratio of a cross-sectional area of a passage opening (OP2451) opened by the pressure adjusting valve (243) to a cross-sectional area of the pipe flow path (2411), , and
wherein the control unit is configured to determine that the cleaning has ended when the opening ratio sequentially satisfies a first period in which the hourly variation of the opening ratio is positive, a second period in which the hourly variation of the opening ratio is negative, a third period in which the hourly variation of the opening ratio is positive, and a fourth period in which the hourly variation of the opening ratio is within a designated range.

2. The display manufacturing apparatus of claim 1, wherein when determining that the cleaning has ended, the control unit is configured to control the cleaning gas supply unit (22) to stop supplying the cleaning gas to the head unit (19).

3. The display manufacturing apparatus of claim 1 or 2, wherein in the fourth period, the hourly variation of the opening ratio is below a threshold.

4. The display manufacturing apparatus of claim 1, 2, or 3, wherein according to switching from the second period to the third period, the cleaning of the head unit (19) is completed.

5. The display manufacturing apparatus of any one of claims 1 to 4, further comprising a process gas supply unit (21) configured to supply a process gas to the head unit (19),
wherein the head unit (19) is configured to spray the process gas into the chamber (11), optionally wherein when determining that the cleaning has ended, the control unit is configured to control the process gas supply unit (21) to supply the process gas to the head unit (19).

6. The display manufacturing apparatus of any one of claims 1 to 5, further comprising a sensing unit (25) arranged in the chamber (11) and configured to sense the pressure in the chamber (11),
wherein the pressure adjusting valve (243) is configured to open or close the pipe flow path (2411) based on information sensed by the sensing unit (25).

7. The display manufacturing apparatus of any one of claims 1 to 6, further comprising a mask (15) arranged in the chamber (11), the mask (15) including a deposition area configured to be arranged over the display substrate.

8. A display manufacturing method comprising:
carrying out (S1) a display substrate to an outside of a chamber (11) from a susceptor (14) arranged in the chamber (11);
supplying (S2) a cleaning gas to a head unit (19) by a cleaning gas supply unit (22);
spraying (S3) the cleaning gas into the chamber (11) by the head unit (19);
conducting (S4) a pressure adjusting operation of adjusting a pressure in the chamber (11) by a pressure adjusting unit (24); and
determining (S5) an end point of cleaning by a control unit,
wherein the pressure adjusting operation comprises:
applying (S41) a designated pressure to a pipe flow path (2411) by a pressure adjusting pump (242) arranged at a guide pipe (241) including the pipe flow path (2411) communicating with an inside of the chamber (11); and
opening or closing (S42) the pipe flow path (2411) by a pressure adjusting valve (243) connected to the guide pipe (241) such that the pressure in the chamber (11) is within a designated range,
wherein the control unit calculates an opening ratio that is a ratio of a cross-sectional area of a passage opening (OP2451) opened by the pressure adjusting valve (243) to a cross-sectional area of the pipe flow path (2411), and, and
wherein the control unit determines that the cleaning has ended when the opening ratio sequentially satisfies a first period in which the hourly variation of the opening ratio is positive, a second period in which the hourly variation of the opening ratio is negative, a third period in which the hourly variation of the opening ratio is positive, and a fourth period in which the hourly variation of the opening ratio is within a designated range.

9. The display manufacturing method of claim 8, wherein when determining (S5) that the cleaning has ended, the control unit controls the cleaning gas supply unit (22) to stop supplying the cleaning gas to the head unit (19).

10. The display manufacturing method of claim 8 or 9, wherein in the fourth period, the hourly variation of the opening ratio is below a threshold.

11. The display manufacturing method of claim 8, 9, or 10, wherein according to switching from the first period to the second period, a portion of the head unit (19) being cleaned gradually moves away from a central axis thereof, and/or wherein according to switching from the second period to the third period, the cleaning of the head unit (19) is completed.

12. The display manufacturing method of any one of claims 8 to 11, further comprising:
supplying (S6) a process gas to the head unit (19) by a process gas supply unit (21); and
spraying (S7) the process gas into the chamber (11) by the head unit (19), optionally wherein when determining that the cleaning has ended the control unit controls the process gas supply unit (21) to supply the process gas to the head unit (19).

13. The display manufacturing method of any one of claims 8 to 12, further comprising a sensing unit (25), wherein the pressure adjusting valve (243) opens or closes the pipe flow path (2411) based on information sensed by a sensing unit (25) arranged in the chamber (11) to sense the pressure in the chamber (11).

14. The display manufacturing method of any one of claims 8 to 13, further comprising providing a mask (15) arranged in the chamber (11), the mask (15) including a deposition area arranged over the display substrate

## Patentansprüche

1. Anzeigeherstellungseinrichtung, umfassend:
eine Kammer (11);
einen Suszeptor (14), der in der Kammer (11) angeordnet und dazu konfiguriert ist, ein Anzeigesubstrat zu stützen;
eine Kopfeinheit (19), die in der Kammer (11) angeordnet und dazu konfiguriert ist, ein Reinigungsgas in die Kammer (11) zu sprühen;
eine Reinigungsgaszufuhreinheit (22), die dazu konfiguriert ist, der Kopfeinheit (19) das Reinigungsgas zuzuführen;
eine Druckregulierungseinheit (24), die dazu konfiguriert ist, einen Druck in der Kammer (11) zu regeln; und
eine Steuereinheit, die dazu konfiguriert ist, einen Endpunkt der Reinigung zu bestimmen,
wobei die Druckregulierungseinheit (24) Folgendes umfasst:
ein Führungsrohr (241), das mit der Kammer (11) verbunden ist und einen Rohrströmungsweg (2411) umfasst, der mit dem Inneren der Kammer (11) in Kommunikation ist;
eine Druckregulierungspumpe (242), die mit dem Führungsrohr (241) verbunden und dazu konfiguriert ist, einen vorgesehenen Druck auf den Rohrströmungsweg (2411) auszuüben, sodass ein Gas in der Kammer (11) nach außen strömt; und
ein Druckregulierungsventil (243), das mit dem Führungsrohr (241) verbunden und dazu konfiguriert ist, den Rohrströmungsweg (2411) zu öffnen oder zu schließen, sodass der Druck in der Kammer (11) innerhalb eines vorgesehenen Bereichs liegt,
wobei die Steuereinheit dazu konfiguriert ist, ein Öffnungsverhältnis zu berechnen, das ein Verhältnis einer Querschnittsfläche einer durch das Druckregulierungsventil (243) geöffneten Kanalöffnung (OP2451) zu einer Querschnittsfläche des Rohrströmungswegs (2411) ist, und
wobei die Steuereinheit dazu konfiguriert ist, zu bestimmen, dass die Reinigung beendet ist, wenn das Öffnungsverhältnis nacheinander eine erste Periode, in der die stündliche Variation des Öffnungsverhältnisses positiv ist, eine zweite Periode, in der die stündliche Variation des Öffnungsverhältnisses negativ ist, eine dritte Periode, in der die stündliche Variation des Öffnungsverhältnisses positiv ist, und eine vierte Periode, in der die stündliche Variation des Öffnungsverhältnisses innerhalb eines vorgesehenen Bereichs liegt, erfüllt.

2. Anzeigeherstellungseinrichtung nach Anspruch 1, wobei, wenn bestimmt wird, dass die Reinigung beendet ist, die Steuereinheit dazu konfiguriert ist, die Reinigungsgaszufuhreinheit (22) zu steuern, Zufuhr des Reinigungsgases zur Kopfeinheit (19) zu stoppen.

3. Anzeigeherstellungseinrichtung nach Anspruch 1 oder 2, wobei in der vierten Periode die stündliche Variation des Öffnungsverhältnisses unterhalb eines Schwellenwerts liegt.

4. Anzeigeherstellungseinrichtung nach Anspruch 1, 2 oder 3, wobei gemäß einem Wechseln von der zweiten Periode zu der dritten Periode, die Reinigung der Kopfeinheit (19) beendet ist.

5. Anzeigeherstellungseinrichtung nach einem der Ansprüche 1 bis 4, ferner umfassend eine Prozessgaszufuhreinheit (21), die dazu konfiguriert ist, der Kopfeinheit (19) ein Prozessgas zuzuführen,
wobei die Kopfeinheit (19) dazu konfiguriert ist, das Prozessgas in die Kammer (11) zu sprühen, wobei, wenn bestimmt wird, dass die Reinigung beendet ist, die Steuereinheit optional dazu konfiguriert ist, die Prozessgaszufuhreinheit (21) zu steuern, der Kopfeinheit (19) das Prozessgas zuzuführen.

6. Anzeigeherstellungseinrichtung nach einem der Ansprüche 1 bis 5, ferner umfassend eine Sensoreinheit (25), die in der Kammer (11) angeordnet und dazu konfiguriert ist, den Druck in der Kammer (11) zu erfassen,
wobei das Druckregulierungsventil (243) dazu konfiguriert ist, den Rohrströmungsweg (2411) basierend auf Informationen zu öffnen und zu schließen, die von der Sensoreinheit (25) erfasst werden.

7. Anzeigeherstellungseinrichtung nach einem der Ansprüche 1 bis 6, ferner umfassend eine in der Kammer (11) angeordnete Maske (15), wobei die Maske (15) einen Abscheidungsbereich einschließt, der dazu konfiguriert ist, über dem Anzeigesubstrat angeordnet zu werden.

8. Anzeigeherstellungsverfahren, umfassend:
Austragen (S1) eines Anzeigesubstrats aus der Kammer (11), von einem Suszeptor (14), der in der Kammer (11) angeordnet ist;
Zuführen (S2) eines Reinigungsgases zu einer Kopfeinheit (19) durch eine Reinigungsgaszufuhreinheit (22);
Sprühen (S3) des Reinigungsgases in die Kammer (11) durch die Kopfeinheit (19);
Durchführen (S4) eines Druckregulierungsvorgangs zum Regulieren eines Drucks in der Kammer (11) durch eine Druckregulierungseinheit (24); und
Bestimmen (S5) eines Reinigungsendpunkts durch eine Steuereinheit,
wobei der Druckregulierungsvorgang Folgendes umfasst:
Ausüben (S41) eines vorgesehenen Drucks auf einen Rohrströmungsweg (2411) durch eine Druckregulierungspumpe (242), die an einem Führungsrohr (241) angeordnet ist, das den Rohrströmungsweg (2411) einschließt, der mit dem Inneren der Kammer (11) in Kommunikation ist; und
Öffnen oder Schließen (S42) des Rohrströmungswegs (2411) durch ein Druckregulierungsventil (243), das mit dem Führungsrohr (241) verbunden ist, sodass der Druck in der Kammer (11) innerhalb eines vorgesehenen Bereichs liegt,
wobei die Steuereinheit ein Öffnungsverhältnis berechnet, das ein Verhältnis einer Querschnittsfläche einer durch das Druckregulierungsventil (243) geöffneten Kanalöffnung (OP2451) zu einer Querschnittsfläche des Rohrströmungswegs (2411) ist, und
wobei die Steuereinheit bestimmt, dass die Reinigung beendet ist, wenn das Öffnungsverhältnis nacheinander eine erste Periode, in der die stündliche Variation des Öffnungsverhältnisses positiv ist, eine zweite Periode, in der die stündliche Variation des Öffnungsverhältnisses negativ ist, eine dritte Periode, in der die stündliche Variation des Öffnungsverhältnisses positiv ist, und eine vierte Periode, in der die stündliche Variation des Öffnungsverhältnisses innerhalb eines vorgesehenen Bereichs liegt, erfüllt.

9. Anzeigeherstellungsverfahren nach Anspruch 8, wobei, wenn bestimmt wird (S5), dass die Reinigung beendet ist, die Steuereinheit die Reinigungsgaszufuhreinheit (22) steuert, Zufuhr des Reinigungsgases zur Kopfeinheit (19) zu stoppen.

10. Anzeigeherstellungsverfahren nach Anspruch 8 oder 9, wobei in der vierten Periode die stündliche Variation des Öffnungsverhältnisses unterhalb eines Schwellenwerts liegt.

11. Anzeigeherstellungsverfahren nach Anspruch 8, 9 oder 10, wobei gemäß einem Wechseln von der ersten Periode zu der zweiten Periode, ein Abschnitt der Kopfeinheit (19), der gereinigt wird, sich allmählich von einer Mittelachse davon wegbewegt, und/oder wobei gemäß einem Wechseln von der zweiten Periode zu der dritten Periode, die Reinigung der Kopfeinheit (19) abgeschlossen wird.

12. Anzeigeherstellungsverfahren nach einem der Ansprüche 8 bis 11, ferner umfassend:
Zuführen (S6) eines Prozessgases zur Kopfeinheit (19) durch eine Prozessgaszufuhreinheit (21); und
Sprühen (S7) des Prozessgases in die Kammer (11) durch die Kopfeinheit (19), wobei, wenn bestimmt wird, dass die Reinigung beendet ist, die Steuereinheit optional die Prozessgaszufuhreinheit (21) steuert, der Kopfeinheit (19) das Prozessgas zuzuführen.

13. Anzeigeherstellungsverfahren nach einem der Ansprüche 8 bis 12, ferner umfassend eine Sensoreinheit (25), wobei das Druckregulierungsventil (243) den Rohrströmungsweg (2411) basierend auf Informationen öffnet oder schließt, die von einer Sensoreinheit (25) erfasst werden, die in der Kammer (11) angeordnet ist, um den Druck in der Kammer (11) zu erfassen.

14. Anzeigeherstellungsverfahren nach einem der Ansprüche 8 bis 13, ferner umfassend Bereitstellen einer in der Kammer (11) angeordneten Maske (15), wobei die Maske (15) einen Abscheidungsbereich einschließt, der über dem Anzeigesubstrat angeordnet ist.

## Revendications

1. Appareil de fabrication d'affichage comprenant :
une chambre (11) ;
un suscepteur (14) disposé dans la chambre (11) et configuré pour supporter un substrat d'affichage ;
une unité de tête (19) disposée dans la chambre (11) et configurée pour pulvériser un gaz de nettoyage dans la chambre (11) ;
une unité d'alimentation en gaz de nettoyage (22) configurée pour fournir le gaz de nettoyage à l'unité de tête (19) ;
une unité de réglage de pression (24) configurée pour régler une pression dans la chambre (11) ; et
une unité de commande configurée pour déterminer un point final de nettoyage,
dans lequel l'unité de réglage de pression (24) comprend :
un tuyau de guidage (241) relié à la chambre (11) et comprenant un chemin d'écoulement de tuyau (2411) communiquant avec l'intérieur de la chambre (11) ;
une pompe de régulation de pression (242) reliée au tuyau de guidage (241) et configurée pour appliquer une pression désignée au chemin d'écoulement du tuyau (2411) de sorte qu'un gaz contenu dans la chambre (11) s'écoule vers l'extérieur de celle-ci ; et
une vanne de réglage de pression (243) reliée au tuyau de guidage (241) et configurée pour ouvrir ou fermer le chemin d'écoulement du tuyau (2411) de sorte que la pression dans la chambre (11) soit dans une plage désignée,
dans lequel l'unité de commande est configurée pour calculer un rapport d'ouverture qui est le rapport entre la surface de la section transversale d'une ouverture de passage (OP2451) ouverte par la vanne de régulation de pression (243) et la surface de la section transversale du chemin d'écoulement du tuyau (2411), et
dans lequel l'unité de commande est configurée pour déterminer que le nettoyage est terminé lorsque le taux d'ouverture satisfait séquentiellement une première période au cours de laquelle la variation horaire du taux d'ouverture est positive, une deuxième période au cours de laquelle la variation horaire du taux d'ouverture est négative, une troisième période au cours de laquelle la variation horaire du taux d'ouverture est positive et une quatrième période au cours de laquelle la variation horaire du taux d'ouverture se situe dans une plage désignée.

2. Appareil de fabrication d'affichage selon la revendication 1, dans lequel, lorsqu'il est déterminé que le nettoyage est terminé, l'unité de commande est configurée pour commander l'unité d'alimentation en gaz de nettoyage (22) afin d'arrêter de fournir le gaz de nettoyage à l'unité de tête (19).

3. Appareil de fabrication d'affichage selon la revendication 1 ou 2, dans lequel, au cours de la quatrième période, la variation horaire du taux d'ouverture est inférieure à un seuil.

4. Appareil de fabrication d'affichage selon la revendication 1, 2 ou 3, dans lequel, en passant de la deuxième période à la troisième période, le nettoyage de l'unité de tête (19) est terminé.

5. Appareil de fabrication d'affichage selon l'une quelconque des revendications 1 à 4, comprenant en outre une unité d'alimentation en gaz de procédé (21) configurée pour fournir un gaz de procédé à l'unité de tête (19),
dans lequel l'unité de tête (19) est configurée pour pulvériser le gaz de procédé dans la chambre (11), en option dans lequel lorsque, lorsqu'il est déterminé que le nettoyage est terminé, l'unité de commande est configurée pour commander l'unité d'alimentation en gaz de procédé (21) afin d'alimenter l'unité de tête (19) en gaz de procédé.

6. Appareil de fabrication d'affichage selon l'une quelconque des revendications 1 à 5, comprenant en outre une unité de détection (25) disposée dans la chambre (11) et configurée pour détecter la pression dans la chambre (11),
dans lequel la vanne de réglage de pression (243) est configurée pour ouvrir ou fermer le chemin d'écoulement du tuyau (2411) en fonction des informations détectées par l'unité de détection (25).

7. Appareil de fabrication d'affichage selon l'une quelconque des revendications 1 à 6, comprenant en outre un masque (15) disposé dans la chambre (11), le masque (15) incluant une zone de dépôt configurée pour être disposée sur le substrat d'affichage.

8. Procédé de fabrication d'affichage, comprenant :
la réalisation (S1) d'un substrat d'affichage à l'extérieur d'une chambre (11) à partir d'un suscepteur (14) disposé dans la chambre (11) ;
la fourniture (S2) d'un gaz de nettoyage à une unité de tête (19) par une unité d'alimentation en gaz de nettoyage (22) ;
la pulvérisation (S3) du gaz de nettoyage dans la chambre (11) par l'unité de tête (19) ;
la réalisation (S4) d'une opération de réglage de pression consistant à ajuster la pression dans la chambre (11) au moyen d'une unité de réglage de pression (24) ; et
la détermination (S5) d'un point final de nettoyage par une unité de commande,
dans lequel l'opération de réglage de la pression comprend :
l'application (S41) d'une pression désignée à un chemin d'écoulement du tuyau (2411) au moyen d'une pompe de régulation de pression (242) disposée sur un tuyau de guidage (241) incluant le chemin d'écoulement du tuyau (2411) communiquant avec l'intérieur de la chambre (11) ; et
l'ouverture ou la fermeture (S42) du chemin d'écoulement du tuyau (2411) par une vanne de réglage de pression (243) reliée au tuyau de guidage (241) de sorte que la pression dans la chambre (11) soit dans une plage désignée,
dans lequel l'unité de commande calcule un rapport d'ouverture qui est le rapport entre la surface de la section transversale d'une ouverture de passage (OP2451) ouverte par la vanne de régulation de pression (243) et la surface de la section transversale du chemin d'écoulement du tuyau (2411), et, et
dans lequel l'unité de commande détermine que le nettoyage est terminé lorsque le taux d'ouverture satisfait séquentiellement une première période au cours de laquelle la variation horaire du taux d'ouverture est positive, une deuxième période au cours de laquelle la variation horaire du taux d'ouverture est négative, une troisième période au cours de laquelle la variation horaire du taux d'ouverture est positive et une quatrième période au cours de laquelle la variation horaire du taux d'ouverture se situe dans une plage désignée.

9. Procédé de fabrication d'affichage selon la revendication 8, dans lequel, lorsqu'il est déterminé (S5) que le nettoyage est terminé, l'unité de commande commande l'unité d'alimentation en gaz de nettoyage (22) pour arrêter de fournir le gaz de nettoyage à l'unité de tête (19).

10. Procédé de fabrication d'affichage selon la revendication 8 ou 9, dans lequel, au cours de la quatrième période, la variation horaire du taux d'ouverture est inférieure à un seuil.

11. Procédé de fabrication d'affichage selon la revendication 8, 9 ou 10, dans lequel, selon le passage de la première période à la deuxième période, une partie de l'unité de tête (19) en cours de nettoyage s'éloigne progressivement de son axe central, et/ou dans lequel, selon le passage de la deuxième période à la troisième période, le nettoyage de l'unité de tête (19) est terminé.

12. Procédé selon l'une quelconque des revendications 8 à 11, comprenant en outre :
l'alimentation (S6) d'un gaz de procédé à l'unité de tête (19) par une unité d'alimentation en gaz de procédé (21) ; et
la pulvérisation (S7) du gaz de procédé dans la chambre (11) par l'unité de tête (19), en option dans lequel, lorsqu'il est déterminé que le nettoyage est terminé, l'unité de commande commande l'unité d'alimentation en gaz de procédé (21) pour fournir le gaz de procédé à l'unité de tête (19).

13. Procédé de fabrication d'affichage selon l'une quelconque des revendications 8 à 12, comprenant en outre une unité de détection (25), dans lequel la vanne de réglage de pression (243) ouvre ou ferme le chemin d'écoulement du tuyau (2411) en fonction des informations détectées par une unité de détection (25) disposée dans la chambre (11) pour détecter la pression dans la chambre (11).

14. Procédé de fabrication d'affichage selon l'une quelconque des revendications 8 à 13, comprenant en outre la fourniture d'un masque (15) disposé dans la chambre (11), le masque (15) incluant une zone de dépôt disposée sur le substrat d'affichage.
